# EUROPEAN PATENT SPECIFICATION

(11) **EP 2 225 176 B1**
(45) Date of publication and mention of the grant of the patent: **23.01.2013**
(21) Application number: 08862146.1
(22) Date of filing: 11.12.2008
(51) Int. Cl.: C01B 33/04, C01B 6/00

(54) **METHODS OF RECOVERING SILANE**
VERFAHREN ZUR GEWINNUNG VON SILAN
PROCÉDÉS DE RÉCUPÉRATION DE SILANE

(30) Priority: 18.12.2007 US 14540
(43) Date of publication of application: 08.09.2010
(73) Proprietor: Linde North America, INC., Murray Hill, NJ 07974 (US)
(72) Inventor: SATCHELL, Donald, Prentice, Jr., Chatham NJ 07928 (US); HOGLE, Richard, Allen, Oceanside CA 92056 (US)
(74) Representative: Gellner, Bernd
(86) International application number: PCT/US2008/086321
(87) International publication number: WO 2009/079314

(56) References cited:
- US-A- 4 460 673
- US-A- 5 151 395
- US-B2- 6 540 819
- US-B2- 6 869 579

## Description

### FIELD OF THE INVENTION

The present invention relates to the recovery of valuable silane products from the off-gas of manufacturing processes. More particularly, the present invention provides methods for the recovery of silane from thin film processes for the production of semiconductor devices, including very large scale integrated circuits, flat panel displays, and thin film solar cells.

### BACKGROUND OF THE INVENTION

Plasma and thermally activated chemical vapor deposition (CVD) processes have long been used to produce semiconductor devices. In many of the processes silicon containing compounds are used to deposit a variety of desired layers. However, only a very small fraction of the silicon content of the feed gas, SiH₄ for example, is effectively utilized in the process, typically less than 5%. A larger fraction of the feed silicon is deposited on the walls of the reaction chamber which necessitates periodic cleaning, such as by removal of the unwanted debris using a plasma activated fluorine containing gas, e.g. NF₃, F₂, or SF₆. The majority, usually greater than 75%, of the silicon feed gas simply passes through the deposition chamber and exits as part of the off-gas. It has been recognized that there are opportunities for reuse and an economic incentive to recover the valuable SiₓH₂ₓ₊₂ (x = 1 & 2) species that exist in the CVD reactor off-gas. However, there are a number of practical problems that have forestalled recovery efforts. For example, nitrogen used as ballast for reactor vacuum pumps significantly dilutes the silicon containing components in the CVD reactor off-gas making recovery difficult. Further, the CVD reactor off-gas alternatively includes rich fuel components (reducing agents), e.g. H₂ and SiₓH₂ₓ₊₂, and highly oxidizing components, e.g. F₂ and O₂ resulting in a risk of fire or explosion when attempting to recover and accumulate silane.

To avoid these risks, both the rich fuel and oxidizing streams from the CVD chamber are typically converted to more stable species, e.g. SiO₂, H₂O, and aqueous HF, by sequential contact with a high temperature flame and an aqueous scrubbing solution. This approach minimizes the risk of fire and explosion but also eliminates the possibility of recovering the valuable SiₓH₂ₓ₊₂ species in the CVD process off-gas stream. Because CVD processes were initially used to produce very small, high value integrated circuits for computers and other electronic devices, the economic incentive to recover the SiₓH₂ₓ₊₂ species from the CVD process off-gas stream was relatively low. However, this incentive has increased proportionally with the increasing use of CVD processes to produce larger area thin film display devices and solar voltaic devices having substantially larger areas and layer thicknesses. These devices require a substantial increase in the gas feed required for production and result in much higher gas feed costs, particularly silane.

US patent 4 460 673 A discloses a method for producing amorphous silicon layers for solar cells or electrophotography by plasma-enhanced chemical vapour deposition through glow-discharge decomposition of a reaction gas containing monosilane or a higher order silicon hydride in a reaction chamber.

Despite the increasing economic incentive to recover the valuable SiₓH₂ₓ₊₂ species in the CVD reactor off-gas, no practical approach has been identified to address the above challenges. Therefore, there remains a need in the art for improvements to methods for the recovery of silane.

### SUMMARY OF THE PRESENT INVENTION

The present invention provides a solution to the unresolved safety issues associated with the recovery of valuable silane by-products from these CVD processes. In particular, the present invention provides a method to recover SiₓH₂ₓ₊₂ species from CVD reactor off-gas, the method comprising:
contacting, at least a portion of the CVD reactor off-gas with silicon particles at an elevated temperature;
increasing the concentration of SiₓH₂ₓ₊₂ species by removing a substantial portion of other species having normal boiling points less than 100 °K; and
purifying the crude SiₓH₂ₓ₊₂ stream to produce the desired silane product.

### BRIEF DESCRIPTION OF THE DRAWINGS

Figure 1 is a block flow diagram showing a conventional process for the treatment of CVD reactor off-gas.

Figure 2 is a block flow diagram for a method to recover silane products from a CVD reactor off-gas in accordance with the present invention.

### DETAILED DESCRIPTION OF THE INVENTION

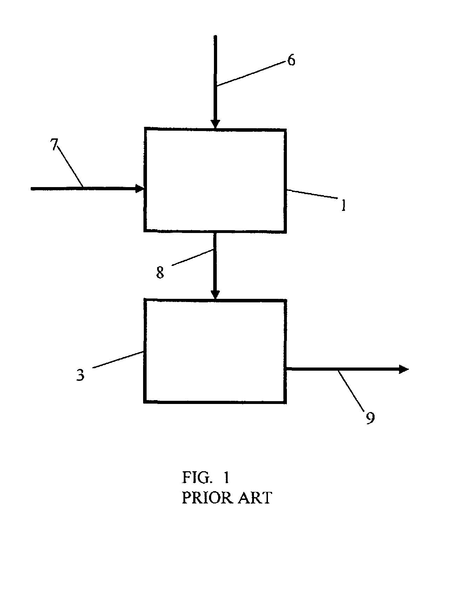

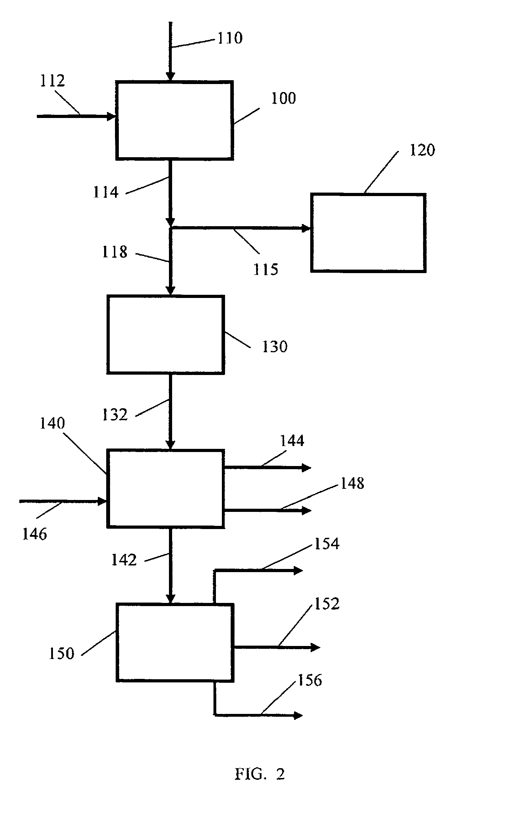

The present invention provides a method to recover SiₓH₂ₓ₊₂ species from CVD reactor off-gas and will be explained in more detail with reference to Figures 1 and 2. In particular, Figure 1 shows a conventional process for treating the off-gas of a CVD reactor. This conventional process comprises a CVD reactor system 1 and a local waste treatment system 3. Process gases 6 are fed to the CVD reactor system 1 to produce the desired semiconductor product. Typically, a large amount of nitrogen 7 is fed to the CVD reactor system 1 vacuum pump to ensure reliable vacuum pump operation. In this conventional process, all of the discharge stream 8 from the CVD reactor system 1 is directed to the local waste treatment system 3. The conventional local waste treatment system 3 generally consists of a burner and an aqueous scrubber column. The objective of the local waste treatment system 3 is to convert the most toxic and reactive species in the discharge stream 8 to much less toxic species in aqueous and gaseous product streams 9 from the local waste treatment system 3. The aqueous and gaseous product streams 9 from a plurality of local waste treatment systems 3 in the production facility may be consolidated for further treatment before discharge. As noted, this conventional off-gas treatment eliminates the possibility of recovering valuable silane products from the off-gas.

The present invention provides a method of recovering silane products from the off-gas of a CVD process as will be explained with reference to Figure 2. In Figure 2, a CVD reactor system 100, has a process gas feed 110 and a nitrogen feed 112, similar to the conventional process shown in Figure 1. As noted the discharge stream 114 composition varies widely from strongly oxidizing to strongly reducing conditions as a function of time in accordance with the CVD reactor system 100 operating conditions used for different semiconductor device manufacturing steps and the chamber cleaning steps between manufacturing steps. Safety considerations require segregation of the strongly oxidizing discharge stream and strongly reducing discharge stream that are alternatively represented by discharge stream 114. Therefore, in accordance with the present invention, the discharge stream 114 is diverted to different systems depending on the composition thereof. In particular, when the discharge stream 114 comes from silicon deposition steps and contains SiₓH₂ₓ₊₂ components, it is diverted through stream 118 to recovery abatement device 130. Conversely, when the discharge stream 114 comes from other manufacturing steps or chamber cleaning steps, it is diverted through stream 115 to the local waste treatment system 120, similar to the conventional process of Figure 1.

The function of the SiₓH₂ₓ₊₂ recovery abatement device 130 is to ensure that oxidizing species, such as F₂ or O₂ from the chamber cleaning or oxidizing manufacturing steps are removed from the stream 118 with minimal SiₓH₂ₓ₊₂ losses. This protects against a valve or other process failure allowing the oxidizing species to proceed with stream 118 instead of being diverted through stream 115. This function is achieved by providing the recovery abatement device 130 comprising a hot granular metallurgical silicon bed maintained at a silicon bed temperature preferably between 200 to 500°C at a pressure slightly above atmospheric pressure, e.g. less than 1.5 bar absolute. The recovery abatement device 130 may be a cylindrical vessel used to contain the silicon bed and a conventional distributor used to improve contact between the stream 118 and the silicon bed. The bed may be heated by any desired heating method to maintain the silicon bed at the desired temperature, including indirect heating of the stream 118 by conduction through a metal wall; indirect heating of the silicon bed through the silicon bed containment wall; electrical resistance heating of the silicon bed; the addition of an oxidant, for example O₂, to heat the silicon bed by combustion; direct contact heat exchange in such a way that the oxidant does not contact the SiₓH₂ₓ₊₂ components; or combinations thereof. The silicon bed is periodically replaced to maintain performance.

A treated stream 132 exits the recovery abatement device 130 and is then treated in a concentration device 140 to produce a product stream 142 that has a much higher SiₓH₂ₓ₊₂ concentration. This is accomplished by removing a substantial portion of the more volatile components in stream 132 that have normal boiling points less than 100°K, e.g. H₂, helium, N₂, and argon, that exit the concentration device 140 via stream 144. In particular, the stream 132 is cooled from the SiₓH₂ₓ₊₂ recovery abatement device 130 operating temperature to a lower temperature, e.g. about room temperature, by indirect cooling. The more volatile components can then be removed by a variety of suitable methods. For example, an increase in pressure allows removal of the more volatile components by pressure swing adsorption or membrane techniques. A preferable method is to use a cryogenic fluid 146, such as liquid nitrogen, to produce the concentrated SiₓH₂ₓ₊₂ product stream 142 by a combination of cryogenic condensation and adsorption or desublimination. This approach offers several advantages. For example, the vaporized nitrogen stream 148 exiting the concentration device 140 can be used as ballast gas for the CVD reactor system 100 vacuum pump. Further, the SiₓH₂ₓ₊₂ liquid or solid can be vaporized and passed to the purification system 150 in product stream 142 at the desired operating pressure without the need for a compression step. The purification system 150 may use conventional distillation to produce the desired SiH₄ product, separate Si₂H₆ and SiH₄ products, and SiH₄-Si₂H₆ product 152. Discard streams of more volatile impurities 154 and less volatile impurities 156 are also removed from the purification system 150 for further treatment and disposal.

It is anticipated that other embodiments and variations of the present invention will become readily apparent to the skilled artisan in the light of the foregoing description, and it is intended that such embodiments and variations likewise be included within the scope of the invention as set out in the appended claims.

## Claims

1. A method of recovering SiₓH₂ₓ₊₂ from the off-gas of a CVD reactor comprising:
contacting at least a portion of the off-gas with silicon particles at an elevated temperature;
removing gas species having normal boiling points less than 100°K from the off-gas to increase the concentration of the SiₓH₂ₓ₊₂; and
purifying the remaining SiₓH₂ₓ₊₂ stream.

2. The method according to claim 1 wherein the silicon particles comprise a granular metallurgical silicon bed and the elevated temperature is 200°C to 500°C.

3. The method of claim 2 wherein the silicon bed is held at a pressure less than 1.5 bar absolute.

4. The method of claim 1 wherein the removed gas species are H₂, helium, N₂, argon or combinations thereof.

5. The method of claim 1 wherein removing gas species comprises a pressure swing absorption or a membrane separation process.

6. The method of claim 1 wherein removing gas species comprises cooling with a cryogenic fluid.

7. The method of claim 6 wherein the cryogenic fluid is liquid nitrogen.

8. The method of claim 1 wherein purifying comprises distillation.

9. The method of claim 1 wherein the SiₓH₂ₓ₊₂ is silane.

10. An apparatus for recovering SiₓH₂ₓ₊₂ from the off-gas of a CVD reactor comprising:
a CVD reactor having a process gas feed, a nitrogen gas feed and a discharge;
a waste treatment system communicating with the discharge of the CVD reactor;
a recovery system communicating with the discharge of the CVD reactor; and
a diversion means to send the off-gas from the CVD reactor to the waste treatment system when the concentration of SiₓH₂ₓ₊₂ in the off-gas is too low to warrant recovery, and to send the off-gas from the CVD reactor to the recovery system when the concentration of SiₓH₂ₓ₊₂ in the off-gas warrants recovery;
wherein the recovery system comprises a silicon bed, means to heat the silicon bed, a concentration device communicating with the silicon bed for removing gas species having normal boiling points less than 100°K, and a purification device communicating with the concentration device.

11. The apparatus of claim 10 wherein the silicon bed is a granular metallurgical silicon bed maintained at a silicon bed temperature between 200°C and 500°C and a pressure less than 1.5 bar absolute.

12. The apparatus of claim 10 wherein the silicon bed is housed in a cylindrical vessel with a distributor.

13. The apparatus of claim 10 wherein the means to heat comprises indirect heating; electrical resistance heating; combustion heating; or direct contact heating.

14. The apparatus of claim 10 wherein the concentration device comprises a pressure swing adsorption system, a membrane separation system, or a cryogenic fluid cooling system.

15. The apparatus of claim 10 wherein the purification device is a distillation system.

## Patentansprüche

1. Verfahren zur Gewinnung von SiₓH₂ₓ₊₂ aus dem Abgas eines CVD-Reaktors, umfassend: Inkontaktbringen mindestens eines Abschnitts des Abgases mit Siliciumteilchen bei einer erhöhten Temperatur; Entfernen der Gasspezies mit normalen Siedepunkten von weniger als 100 °K aus dem Abgas, um die Konzentration von SiₓH₂ₓ₊₂ zu erhöhen; und Aufreinigen des verbleibenden SiₓH₂ₓ₊₂-Stroms.

2. Verfahren nach Anspruch 1, wobei die Siliciumteilchen ein granulöses metallurgisches Siliciumbett umfassen und die erhöhte Temperatur 200 °C bis 500 °C ist.

3. Verfahren nach Anspruch 2, wobei das Siliciumbett bei einem Druck von weniger als 1,5 bar absolut gehalten wird.

4. Verfahren nach Anspruch 1, wobei die entfernte Gasspezies H₂, Helium, N₂, Argon oder Kombinationen davon ist.

5. Verfahren nach Anspruch 1, wobei das Entfernen der Gasspezies eine Druckwechseladsorption oder ein Membranenabscheidungsverfahren umfasst.

6. Verfahren nach Anspruch 1, wobei das Entfernen der Gasspezies das Kühlen mit einer kryogenen Flüssigkeit umfasst.

7. Verfahren nach Anspruch 6, wobei die kryogene Flüssigkeit flüssiger Stickstoff ist.

8. Verfahren nach Anspruch 1, wobei das Reinigen Destillation umfasst.

9. Verfahren nach Anspruch 1, wobei das SiₓH₂ₓ₊₂ Silan ist.

10. Vorrichtung zur Gewinnung von SiₓH₂ₓ₊₂ aus dem Abgas eines CVD-Reaktors, umfassend: einen CVD-Reaktor mit einer Prozessgaszufuhr, einer Stickstoffgaszufuhr und einem Ablass; ein Abfallbehandlungssystem, das mit dem Ablass des CVD-Reaktors verbunden ist; ein Wiedergewinnungssystem, das mit dem Ablass des CVD-Reaktors verbunden ist; ein Ausschleusungsmittel, um das Abgas aus dem CVD-Reaktor zu dem Abfallbehandlungssystem zu senden, wenn die Konzentration von SiₓH₂ₓ₊₂ in dem Abgas zu gering ist, um eine Wiedergewinnung zu gewährleisten, und um das Abgas aus dem CVD-Reaktor zu dem Wiedergewinnungssystem zu senden, wenn die Konzentration von SiₓH₂ₓ₊₂ in dem Abgas eine Wiedergewinnung gewährleistet; wobei das Wiedergewinnungssystem ein Siliciumbett, Mittel zum Erwärmen des Siliciumbetts, eine Konzentrationsvorrichtung, die mit dem Siliciumbett verbunden ist, um Gasspezies mit normalen Siedepunkten von weniger als 100°K zu entfernen, und eine Reinigungsvorrichtung umfasst, die mit der Konzentrationsvorrichtung verbunden ist.

11. Vorrichtung nach Anspruch 10, wobei das Siliciumbett ein granulöses metallurgisches Siliciumbett ist, das bei einer Siliciumbetttemperatur zwischen 200 °C und 500 °C und einem Druck von weniger als 1,5 bar absolut gehalten wird.

12. Vorrichtung nach Anspruch 10, wobei das Siliciumbett in einem zylinderförmigen Behälter mit einem Verteiler untergebracht ist.

13. Vorrichtung nach Anspruch 10, wobei das Mittel zum Erwärmen eine indirekte Erwärmung, elektrische Widerstandsheizung, Verbrennungserwärmung oder Direktkontakterwärmung umfasst.

14. Vorrichtung nach Anspruch 10, wobei die Konzentrationsvorrichtung ein Druckwechseladsorptionssystem, ein Membranabscheidungssystem oder ein kryogenes Flüssigkeitskühlsystem umfasst.

15. Vorrichtung nach Anspruch 10, wobei die Reinigungsvorrichtung ein Destillationssystem ist.

## Revendications

1. Procédé de récupération de SiₓH₂ₓ₊₂ à partir des effluents gazeux d'un réacteur de CVD, comprenant :
la mise en contact d'au moins une partie des effluents gazeux avec des particules de silicium à une température élevée ;
le retrait des espèces gazeuses ayant des points d'ébullition normaux inférieurs à 100 °K des effluents gazeux pour augmenter la concentration du SiₓH₂ₓ₊₂ ; et
la purification du courant de SiₓH₂ₓ₊₂ restant.

2. Procédé selon la revendication 1 dans lequel les particules de silicium comprennent un lit de silicium métallurgique granulaire et la température élevée est de 200 °C à 500 °C.

3. Procédé selon la revendication 2 dans lequel le lit de silicium est maintenu à une pression inférieure à 1,5 bar absolu.

4. Procédé selon la revendication 1 dans lequel les espèces gazeuses retirées sont H₂, l'hélium, N₂, l'argon ou des combinaisons de ceux-ci.

5. Procédé selon la revendication 1 dans lequel le retrait des espèces gazeuses comprend une adsorption modulée en pression d'un procédé de séparation par membrane.

6. Procédé selon la revendication 1 dans lequel le retrait des espèces gazeuses comprend un refroidissement avec un fluide cryogénique.

7. Procédé selon la revendication 6 dans lequel le fluide cryogénique est l'azote liquide.

8. Procédé selon la revendication 1 dans lequel la purification comprend une distillation.

9. Procédé selon la revendication 1 dans lequel le SiₓH₂ₓ₊₂ est le silane.

10. Appareil pour récupérer du SiₓH₂ₓ₊₂ à partir des effluents gazeux d'un réacteur de CVD, comprenant :
un réacteur de CVD comportant une alimentation en gaz de procédé, une alimentation en azote gazeux et une évacuation ;
un système de traitement des déchets communiquant avec l'évacuation du réacteur de CVD ;
un système de récupération communiquant avec l'évacuation du réacteur de CVD ; et
un moyen de dérivation pour envoyer les effluents gazeux du réacteur de CVD au système de traitement des déchets quand la concentration de SiₓH₂ₓ₊₂ dans les effluents gazeux est trop basse pour garantir une récupération, et pour envoyer les effluents gazeux du réacteur de CVD au système de récupération quand la concentration de SiₓH₂ₓ₊₂ dans les effluents gazeux garantis une récupération ;
dans lequel le système de récupération comprend un lit de silicium, un moyen pour chauffer le lit de silicium, un dispositif de concentration communiquant avec le lit de silicium pour retirer les espèces gazeuses ayant des points d'ébullition normaux inférieurs à 100 °K, et un dispositif de purification communiquant avec le dispositif de concentration.

11. Appareil selon la revendication 10 dans lequel le lit de silicium est un lit de silicium métallurgique granulaire maintenu à une température de lit de silicium entre 200 °C et 500 °C et une pression inférieure à 1,5 bar absolu.

12. Appareil selon la revendication 10 dans lequel le lit de silicium est contenu dans une cuve cylindrique avec un distributeur.

13. Appareil selon la revendication 10 dans lequel le moyen de chauffage comprend un chauffage indirect, un chauffage par résistance électrique, un chauffage par combustion, ou un chauffage par contact direct.

14. Appareil selon la revendication 10 dans lequel le dispositif de concentration comprend un système d'adsorption modulée en pression, un système de séparation par membrane, ou un système de refroidissement par fluide cryogénique.

15. Appareil selon la revendication 10 dans lequel le dispositif de purification est un système de distillation.
